# FASCICULE DE BREVET EUROPEEN

(11) **EP 0 718 887 B1**
(45) Date de publication et mention de la délivrance du brevet: **19.05.1999**
(21) Numéro de dépôt: 95402912.0
(22) Date de dépôt: 21.12.1995
(51) Int. Cl.: H01L 27/08

(54) **Circuit d'étalonnage de résistances**
Abgleichschaltung für Widerstände
Calibration circuit for resistors

(30) Priorité: 23.12.1994 FR 9415553
(43) Date de publication de la demande: 26.06.1996
(73) Titulaire: STMicroelectronics S.A., 94250 Gentilly (FR)
(72) Inventeur: Tailliet, François, F-75116 Paris (FR)
(74) Mandataire: Schmit, Christian Norbert Marie

(56) Documents cités:
- DE-A- 4 238 114
- PATENT ABSTRACTS OF JAPAN vol. 006, no. 092 (P-119) 29 Mai 1982 & JP-A-57 028 227 (SEIKO EPSON CORP) 15 Février 1982

## Description

La présente invention se rapporte à un circuit d'étalonnage de résistances. Plus précisément, la présente invention se rapporte à un circuit d'étalonnage de résistance qui maintient les valeurs de résistance dans un circuit intégré sensiblement constantes lors de la variation d'un facteur physique, notamment la température du circuit intégré.

Les procédés de fabrication de résistances diffusées ou à implantation ionique sont bien connus dans la technique de fabrication de semi-conducteurs. Dans cette technique, il est également bien connu que la valeur de résistance d'une résistance à diffusion élevée ou à implantation ionique élevée varie moins, par rapport à la température, que la valeur de résistance de résistances à faible diffusion ou à faible implantation ionique.

Cependant, pour intégrer dans un circuit intégré des résistances dont les valeurs de résistance sont élevées, c'est à dire des résistances avec des valeurs de résistance supérieures à environ 5 Kohms, et présentant des caractéristiques de faible sensibilité à la température ou, autrement dit, une faible variation de résistance sur une plage précise de température, ou d'un autre facteur, il est nécessaire que celles-ci possèdent une surface importante. En effet, quand des zones sont fortement diffusées la résistivité de ces zones est faible. Cela peut aboutir en une augmentation sensible de la surface de matrice d'un circuit intégré possédant un certain nombre de ces types de résistances, même lorsque ces résistances sont serpentées.

La valeur de résistance R requise est connue parmi les spécialistes de la technique comme étant proportionnelle à la résistivité en couche Rₛ pour une surface géométrique donnée. Ainsi, pour une valeur donnée de Rₛ, la valeur R peut être augmentée en augmentant la surface géométrique de la résistance. De façon alternative, pour une surface géométrique donnée, il est également connu des spécialistes de la technique que la valeur R peut être réglée en modifiant la valeur de Rₛ. La valeur de Rₛ peut être réglée en utilisant un quelconque, ou une combinaison, de procédés connus, notamment en modifiant: le niveau de dopage; la profondeur de diffusion; le(s) profil(s) de dopage; la température de recuit et/ou la durée de recuit.

Il serait avantageux de disposer d'une surface géométrique optimale pour les résistances requises puis de varier les valeurs de résistance requises de ces résistances en utilisant un quelconque, ou une combinaison, des procédés mentionnés ci-dessus. Cependant, pour une disposition géométrique donnée il existe des inconvénients associés aux procédés connus pour fabriquer de telles résistances. Notamment: il serait difficile d'augmenter la valeur des résistances en diminuant la profondeur de diffusion/implantation à un niveau quelconque inférieur à environ 0,1 mm du fait des effets de "pincement". Par ailleurs, une résistance de valeur élevée légèrement dopée subira l'inconvénient d'une variation sensible de la résistance selon les changements de température. Les durées et/ou températures de recuit peuvent ne pas être compatibles avec les autres composants intégrés passifs et/ou actifs. La fabrication de telles résistances implique des étapes de processus supplémentaires.

A titre d'exemple, dans le brevet américain 3 902 926 (Perloff et al) un procédé est décrit pour réaliser une résistance à implantation ionique dont le coefficient de température est commandé. Cependant, un tel procédé présente un inconvénient dans la mesure où les étapes de fabrication et de traitement associées à la réalisation d'une telle résistance sont trop nombreuses et compliquées, comme c'est également cas avec le brevet américain 3 947 866 (Stellrecht). Un autre circuit est décrit dans JP-A-57028227

Par conséquent, un objet de la présente invention consiste à prévoir un circuit étalon de résistance sensiblement indépendant d'un facteur physique déterminé et pouvant compenser des variations du facteur physique de telle façon que les résistances dans un système associé, lesquelles dépendent du facteur physique, puissent être compensées de façon à prendre en compte des variations du facteur physique.

Un autre objet de la présente invention consiste à prévoir un système étalon de résistance pouvant être utilisé pour déterminer si un système associé a été soumis au facteur physique au-delà de la plage spécifiée.

Afin de réaliser ces objets, la présente invention telle que revendiquée dans la revendication 1 prévoit un circuit étalon de résistance comprenant : une résistance étalon sensiblement indépendante d'un facteur physique déterminé auquel est soumis le circuit étalon de résistance, par exemple la température, la tension d'alimentation, la tolérance du procédé de fabrication ; un réseau de résistances qui dépend dudit facteur physique déterminé ; un circuit de source de courant destiné à fournir respectivement un premier et un deuxième courant à la résistance étalon et au réseau de résistances ; un circuit comparateur et logique comportant un comparateur sensible aux tensions établies à travers la résistance étalon et le réseau de résistances et une multiplicité d'interrupteurs reliés respectivement aux résistances dudit réseau de résistances, lesdits interrupteurs étant commandés par le comparateur de manière à modifier la valeur de résistance du réseau de résistances de façon à ce que la valeur de résistance du réseau de résistances soit maintenue sensiblement à un niveau correspondant à celui de la résistance étalon.

Selon un autre mode de réalisation de la présente invention, le circuit de source de courant comporte une première et une deuxième source de courant fournissant respectivement un premier et un deuxième courant qui sont, de préférence, sensiblement pareils et de préférence avec des variations du facteur physique.

Selon un autre mode de réalisation de la présente invention, le réseau de résistances comprend une multiplicité de résistances reliées en série.

Selon un autre mode de réalisation de la présente invention, le réseau de résistances comprend une multiplicité de résistances reliées en parallèle.

Selon d'autres modes de réalisation de la présente invention, il est inclus, parmi les moyens, un compteur, tel un compteur-décompteur binaire par exemple, sensible à un signal d'horloge ou de comptage, à un signal de restauration destiné à restaurer une valeur de comptage prédéterminée pour le compteur, et à la sortie du comparateur.

Selon un autre mode de réalisation de la présente invention, la commande de la multiplicité d'interrupteurs est relayée par l'intermédiaire d'un bus de données.

Selon d'autres modes de réalisation de la présente invention, un élément de stockage est relié au bus de données (205). L'élément de stockage, ou mémoire, étant par exemple une mémoire EPROM, EEPROM ou Flash EEPROM ou tout autre moyen approprié.

Selon d'autres modes de réalisation de la présente invention, un ou plusieurs autres réseaux de résistances commutées sont envisagés et, de préférence, modifiés en concordance avec ledit réseau de résistances. En outre, le réseau de résistances et/ou ces autres réseaux de résistances commutées constituent, de préférence, l'extension de drain et/ou de source d'un transistor du type MOS.

Selon d'autres modes de réalisation de la présente invention, les valeurs de résistance du réseau de résistances commutées et/ou des autres réseaux de résistances sont pondérées en binaire, de préférence progressivement.

Ceux-ci et d'autres objets, ainsi que d'autres avantages et caractéristiques, de la présente invention ressortiront plus clairement à la lecture de la description détaillée ci-après et des dessins joints, présentés à titre non-limitatif, dans lesquels :
La figure 1 représente un schéma fonctionnel d'un mode de réalisation d'un circuit étalon de résistance selon l'invention ;
La figure 2 représente un schéma fonctionnel d'un mode de réalisation d'un système étalon de résistance selon l'invention ;
La figure 3a représente un mode de réalisation d'un transistor MOS possédant une extension de drain correspondant à une résistance selon l'invention;
La figure 3b représente un mode de réalisation d'une vue de dessus d'un réseau de résistances pondérées serpenté selon l'invention; et
La figure 3c représente un schéma des circuits correspondant à la figure 3a.

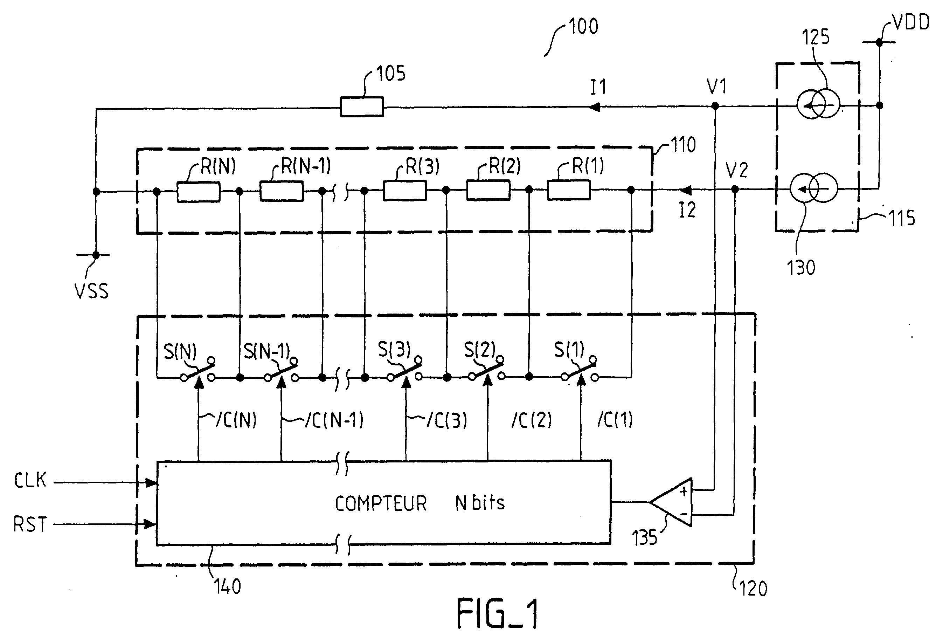

La figure 1 représente un schéma fonctionnel d'un mode de réalisation d'un circuit étalon de résistance selon l'invention. Le circuit étalon de résistance 100 comporte une résistance étalon 105, un réseau de résistances 110, un circuit de source de courant 115 et un circuit de commande 120 agissant comme comparateur et circuit logique. La résistance étalon 105 et le réseau de résistances 110 possèdent une entrée et une sortie chacun.

Dans ce mode de réalisation particulier, le circuit de source de courant 115 comprend deux sources de courant 125, 130, alimentées par une source de tension positive VDD. Elles fournissent respectivement les courants I1 et I2 aux entrées de la résistance étalon 105 et du réseau de résistances 110. Les sorties de la résistance étalon 105 et du réseau de résistances 110 sont reliées à une autre source de tension VSS, dans un exemple, moins élevée. Concernant le circuit de source de courant 115, la caractéristique essentielle de celui-ci est qu'il est capable de fournir des courants I1, I2 qui demeurent sensiblement pareils, même lors d'une variation importante d'un facteur physique, la température par exemple. Il est possible de mettre en oeuvre le circuit de source de courant 115 par l'intermédiaire d'un miroir de courant (non représenté) par exemple, ou tout autre dispositif approprié connu des spécialistes de la technique.

Le réseau de résistances 110 est représenté comme comprenant une multiplicité de résistances reliées en série R(1), R(2)... R(N-1), R(N), tandis que la résistance étalon 105 est représentée comme comprenant une seule résistance. Le réseau de résistances 110 comporte deux résistances ou plus, c'est à dire N ≥ 2, tandis que la résistance étalon 105 peut être formée par une ou plusieurs résistances. La forme et la nature de la résistance étalon 105 et du réseau de résistances 110 seront examinées de façon plus détaillée ci-dessous.

Le circuit de commande 120 comporte un comparateur 135, un compteur 140 et une multiplicité d'interrupteurs S(1), S(2),... S(N-1), S(N). Le comparateur 135 compare les tensions établies à travers la résistance étalon 105 et le réseau de résistances 110. A titre d'exemple, la borne d'entrée positive du comparateur 135 reçoit une tension V1 qui correspond à la tension établie à travers la résistance étalon 105. Une tension V2 correspondant à la tension établie à travers le réseau de résistances 110 est fournie à la borne d'entrée négative du comparateur 135.

Ainsi, lorsque la tension V1 est supérieure à la tension V2, la sortie du comparateur est en état logique 1. Etant donné que, tel que mentionné ci-dessus, I1 est sensiblement égal à I2, cela veut dire que la valeur de la résistance du réseau 110 est inférieure à celle de la résistance étalon 105. De façon alternative, lorsque la tension V2 est supérieure à la tension V1, la sortie du comparateur est en état logique 0, ce qui veut dire que la valeur de la résistance du réseau 110 est supérieure à celle de la résistance étalon 105.

Le compteur 145, qui est de préférence un compteur-décompteur binaire pondéré progressivement, reçoit la sortie du comparateur 135 et un signal de comptage, c'est à dire un signal d'horloge CLK, et de préférence un signal de restauration RST. Le signal CLK sert à "compter" dans le compteur 140 un état logique en cours au niveau de la sortie du comparateur 135. A titre d'exemple, chaque fois que le signal CLK apparaît et que la sortie du comparateur 135 est en état logique 1, le compteur fait progresser sa valeur de comptage d'une valeur binaire de poids faible (LSB). Cependant, si le comparateur 135 est en état logique 0, le compteur diminue sa valeur de comptage d'une valeur LSB. Le compteur 140 est muni de N sorties délivrant N signaux de commande C(1), C(2)... C(N-1), C(N), qui commandent chacun un interrupteur S(1), S(2)... S(N-1), S(N) individuellement. Ces N sorties de commande fournissent des signaux correspondant aux 2^{N} états binaires possibles du compteur 140. La fréquence de l'horloge peut être régulière, irrégulière ou déterminée par l'utilisateur et/ou par le système. Le signal RST sert à restaurer le compteur, pendant la phase de mise sous tension du système par exemple, de façon à ce que celui-ci possède une valeur de comptage prédéterminée, 0 par exemple.

Les N interrupteurs sont reliés entre eux en série. Ils sont également respectivement reliés en parallèle à chacune des N résistances du réseau de résistances 110. Les interrupteurs peuvent donc être manipulés par les signaux de commande C(1) ... C(N-1), C(N) du compteur 140 de façon à modifier la valeur de résistance du réseau de résistances 110 soit en court-circuitant, soit en ne court-circuitant pas leur résistance associée reliée en parallèle. De préférence les commutateurs seront même commandés par les signaux /C(N) complémentaire des signaux C(N). Par exemple: le interrupteur S(1) est relié en parallèle à la résistance R(1) et commandé par le signal de commande /C(1) du compteur 140. Le interrupteur S(2), lequel est relié en série entre les interrupteurs S(1) et S(3), est relié en parallèle à la résistance R(2), laquelle est reliée en série entre les résistances R(1) et R(3). Le interrupteur S(2) est commandé par le signal de commande /C(2) du compteur 140, et ainsi de suite. Les interrupteurs peuvent être mis en oeuvre soit avec des portes de transmission CMOS reliées et commandées de façon appropriée, soit avec des transistors MOS du type n ou du type p reliés et commandés de façon appropriée.

La résistance étalon 105 doit être réalisée de façon à ce que la variation de résistance soit aussi petite que possible lors d'une variation importante d'un facteur physique telle la température. A titre d'exemple, une variation de résistance de 1% sur une plage de température de -55°C à +125°C constitue une variation typique. Une telle résistance peut être fabriquée sur un circuit intégré au moyen, par exemple, d'une résistance à haute diffusion ou à forte implantation ionique. Le(s) procédé(s) de fabrication d'une telle résistance est connu des spécialistes de la technique. Cependant, une résistance étalon 105 à haute diffusion ou à forte implantation ionique avec une valeur de résistance élevée occupera, tel que mentionné ci-dessus, une surface importante par rapport à une résistance équivalente à faible diffusion ou à faible implantation ionique. Cette surface aura tout de même peu d'importance par rapport à la surface de matrice totale du fait que la présente invention prévoit qu'une seule de ces résistances 105 soit nécessaire. Cette résistance étalon 105 peut être réalisée de façon à avoir une valeur de résistance de 10Kohms, par exemple, à une température T égale à 25°C.

Par contre, le réseau de résistances 110 peut être mis en oeuvre avec une multiplicité de résistances à faible diffusion ou à faible implantation ionique, lesquelles occuperont de façon inhérente une surface de matrice inférieure à celle occupée par par une résistance équivalente à haute diffusion ou à forte implantation ionique. Il est préférable que ces résistances à faible diffusion ou à faible implantation ionique possèdent des valeurs pondérées en binaire de façon progressive. A titre d'exemple, le réseau 110 peut comprendre huit résistances, c'est à dire N = 8, selon quoi : R(1) = 62,5ohms, R(2) = [2xR(1)], R(3) = [4xR(1)] ... R(8) = [128xR(1)] à une température T = 25°C. En conséquence, à T = 25°C la plage de résistance du réseau 110 est d'environ 62,5ohms, correspondant à la résistance R(1), jusqu'à 15,9Kohms, correspondant aux résistances R(1) à R(8) reliées en série.

Tel que mentionné ci-dessus, il est connu que les valeurs de résistance pour des résistances à faible diffusion ou à faible implantation ionique varient sensiblement selon la température. Toutefois, les résistances constituant le réseau 110 varieront toutes proportionnellement de la même quantité. En conséquence, le nombre de résistances (N) constituant le réseau 110 et leurs pondérations respectives peut être tel qu'elles puissent être sélectionnées avec précision par le contrôleur 120 de façon à correspondre sensiblement ou proportionnellement à la valeur de résistance (10Kohms) de la résistance étalon 105 pour la variation de température la plus importante possible.

Afin d'expliquer le fonctionnement du schéma représenté sur la figure 1, on prendra en considération les conditions initiales suivantes suite à la mise sous tension : T = 25°C; la résistance 105 possède une valeur de résistance de 10Kohms; N = 8; R(1) = 62,50hms, R(2) = [2xR(1)], R(3) = [4xR(1)]...R(8) = [128xR(1)] = 8Kohms; tous les interrupteurs à l'exception des interrupteurs S(8) et S(6) sont fermés ; et les signaux d'horloge CLK et de restauration RST sont inactifs.

Supposons maintenant que la température augmente à T = 100°C et que les résistances du réseau ont augmenté leurs valeurs de résistance de 15% pour un changement de température de T = 25°C à T = 100°C, c'est à dire que les résistances du réseau 110 ont un coefficient de température positif (bien entendu, elles peuvent également avoir un coefficient de température négatif), et que, au cours du même changement de température, la résistance étalon n'est modifiée que de 0,5%. Ainsi, la valeur de R(1) est modifiée de 62,5ohms (à 25°C) à environ 71,87 ohms (à 100°C). Il s'ensuit que, étant donné que toutes les résistances du réseau 110 ont le même coefficient de température, R(2) = 2xR(1) ≈ 143,70hms ... R(8) = 128xR(1) ≈ 9,2Kohms. La valeur de la résistance étalon est modifiée de 10Kohms à 10,05Kohms et une telle modification peut être considérée comme étant négligeable.

Le compteur 140 ne comptera pas s'il ne reçoit pas une impulsion d'horloge, quel que soit l'état de la sortie du comparateur 135. Si l'on suppose qu'aucun signal d'horloge CLK ou signal de restauration RST n'a été reçu par le compteur pendant le changement de température de T = 25°C à T = 100°C, la valeur de résistance du réseau 110 correspond à la somme des résistances reliées en série R(8), c'est à dire environ 9,2Kohms, et R(6), c'est à dire environ 2,3Kohms, toutes les autres résistances étant court-circuitées par leurs interrupteurs reliés en parallèle respectifs. Ainsi, à T = 100°C la valeur de résistance de la résistance étalon est de 10,05Kohms tandis que le réseau de résistances 110 a une valeur de résistance totale d'environ (128 + 32)xR(1) =160x(71,87ohms) = 11,5Kohms. En conséquence, étant donné que I1 est sensiblement égal à I2, la tension V2 sera supérieure à la tension V1 et la sortie du comparateur sera en état logique 0.

Supposons maintenant qu'un signal d'horloge arrive. Ce signal d'horloge CLK "comptera" la sortie du comparateur 135 dans le compteur, c'est à dire un état logique 0, diminuant ainsi la valeur de comptage d'une valeur LSB de façon à ce que la résistance totale du réseau 110 soit maintenant égale à (159)xR(1) = 159x(71,870hms) ≈ 11,428Kohms. Cette valeur de résistance du réseau est toujours supérieure à celle de la résistance étalon, ce qui veut dire que l'état logique de sortie du comparateur est toujours 0 car V2 est toujours supérieure à V1. Un autre signal d'horloge arrive, lequel diminue encore la valeur de comptage d'une valeur LSB de plus. Une nouvelle fois cependant, la tension V2 est supérieure à la tension V1.

Supposons maintenant que la fréquence de l'horloge est de 1 Hz. En conséquence, le compteur 140 effectuera un comptage à rebours jusqu'à ce que la valeur de résistance du réseau 110 soit inférieure à celle de la résistance étalon 105, c'est à dire jusqu'à ce que la valeur de la tension V1 soit supérieure à celle de V2. Le compteur fera ensuite progresser la valeur de comptage jusqu'à ce que la valeur de V2 soit supérieure à celle de V1, puis il effectuera une nouvelle fois un comptage à rebours et ainsi de suite.

Il peut être envisagé de laisser la valeur de résistance du réseau 110 osciller autour de celle de la résistance étalon. Cependant, dans la pratique il est préférable que le comparateur 135, ou contrôleur 140, dispose d'un moyen, d'hystérésis par exemple, permettant d'arrêter l'oscillation de la valeur de résistance du réseau autour de celle de la résistance étalon. En conséquence, dans une situation réelle, la sortie du compteur aurait une valeur binaire 10001011 poids faible à droite, correspondant à la valeur décimale 139, ce qui donne une valeur de résistance du réseau de 139x(71,870hms) ≈ 9,99Kohms, laquelle se trouve dans les limites de précision requises.

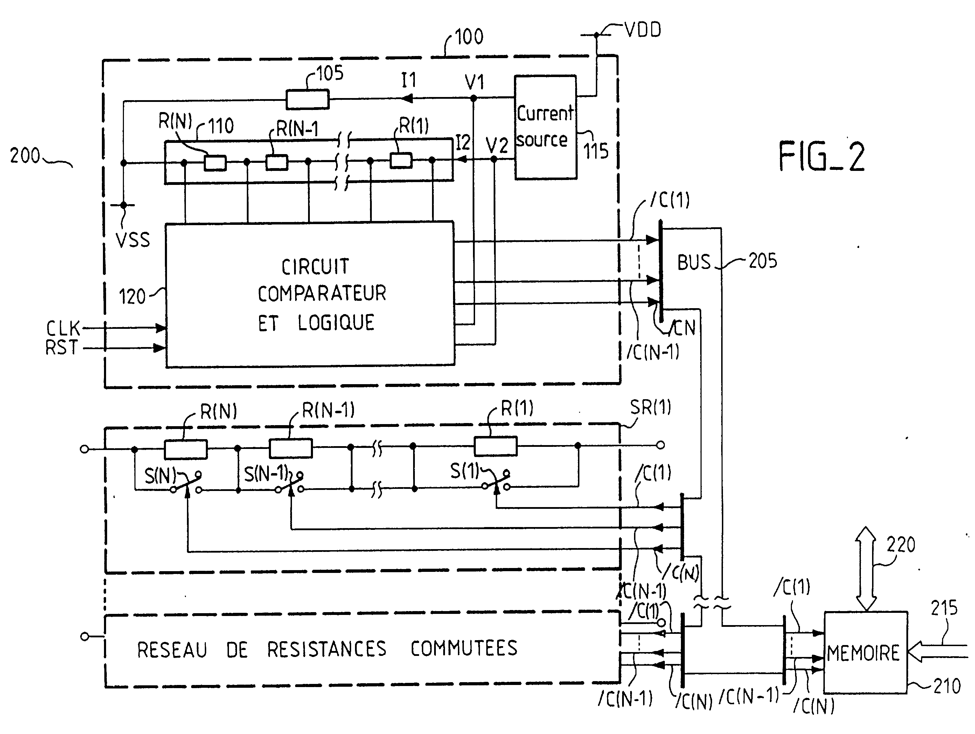

La figure 2 représente un schéma fonctionnel d'un mode de réalisation d'un système étalon de résistance selon l'invention. Le système étalon de résistance comporte le circuit étalon de résistance 100 représenté sur la figure 1, un bus de données 205, un ou plusieurs autres réseaux de résistances commutées SR(1) ... SR(X), où X peut être un nombre entier supérieur ou égal à 2, et une mémoire 210.

Les signaux de commande C(1) ... C(N-1), C(N) du circuit 100 sont acheminés par un bus 205 afin de les aiguiller autour du système.

Les réseaux de résistances commutées SR(1) ... SR(X) sont repartis dans plusieurs emplacements dans tout le système et peuvent être distants du circuit étalon de résistance 100. Chacun de ces réseaux de résistances commutées SR(1) ... SR(X) comporte un réseau de résistances et ses interrupteurs associés reliés en parallèle correspondant respectivement au réseau de résistances 110 et aux N interrupteurs S(1) ... S(N-1), S(N) de la figure 1. Les réseaux commutés SR(1) ... SR(X) sont commandés par le compteur 140 en conformité avec le fonctionnement du réseau 110 et des interrupteurs S(1) ... S(N-1), S(N) de la figure 1. Par conséquent, les réseaux de résistances commutées peuvent être commandés et donc configurés de façon à ce que leurs valeurs de résistance correspondent à celle de la résistance étalon 105. De façon alternative, le réseau de résistances 110 et/ou les réseaux de résistances commutées SR(1) ... SR(X) peuvent être commandés, et donc configurés, de façon à ce que leurs valeurs de résistance correspondent proportionnellement à celle de la résistance étalon 105.

La mémoire 210, qui peut être une mémoire EEPROM par exemple, peut être employée pour mémoriser les signaux de commande C(1) ... C(N-1), C(N). A titre d'exemple, un des avantages que présente le stockage de ces données est que l'utilisateur peut accéder aux données stockées dans la mémoire 210 par l'intermédiaire de bus de commande et de données respectivement 215 et 220, de façon à déterminer la température maximale et/ou minimale atteinte par le circuit intégré. De façon alternative, un tel dispositif peut être incorporé dans un système par le fabricant du circuit intégré, éventuellement sans que l'utilisateur le sache, de façon à ce que, lorsqu'une ou plusieurs pièces contenant le système sont renvoyées au fabriquant suite à une panne, le fabriquant puisse déterminer si, oui ou non, l'utilisateur a dépassé la température limite maximale et/ou minimale spécifiée. Cette application peut être importante afin de déterminer si le client est responsable de l'impossibilité de fonctionnement des pièces, que ce soit une impossibilité de fonctionnement totale ou partielle. Plusieurs autres applications associées seront évidentes pour les spécialistes de la technique, par exemple: vérification des températures utilisées au cours des phases de vieillissement, évaluation des variations de fabrication de lots de plaquettes, etc.

Les réseaux de résistances commutées SR(1) ... SR(X) peuvent être employés dans grand nombre de différents circuits, par exemple: comme références dans des circuits à barrière de potentiel dit "bandgap", dans un amplificateur opérationnel, etc. Ils peuvent également être employés dans la source de courant 115 des figures 1 et 2 et même dans la mémoire 210 de la figure 2.

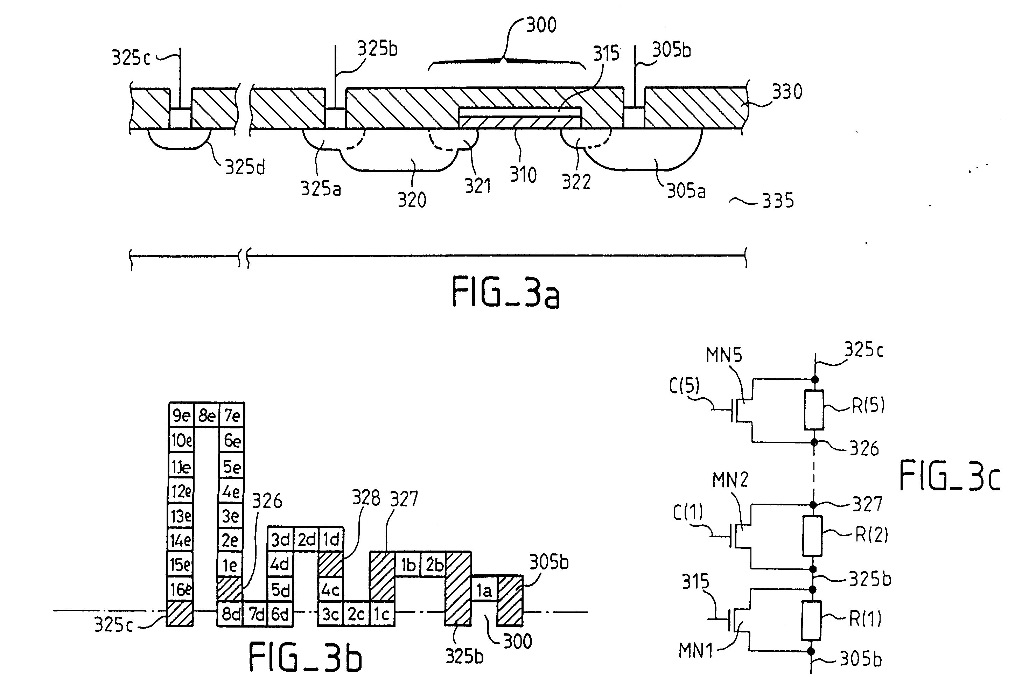

La figure 3a représente un mode de réalisation d'un transistor MOS possédant une extension de drain correspondant à une résistance. Plus précisément, la figure 3a représente la vue en coupe d'un transistor MOS 300 du type n, possédant une extension de drain 321 et une extensions de source 322. Ces extensions correspondent à des zones faiblement dopées. Elle montre également une zone diffusée 325a-325d correspondant à un réseau de résistances réalisées en même temps et avec des mêmes phases de procédé que les extensions de drain et source 321 322. Le procédé pour réaliser un transistor MOS, soit du type n, soit du type p, avec une extension de drain et/ou de source correspondant à une résistance est connu des spécialistes de la technique. Cependant, la présente invention élargit ce principe en incluant un réseau de résistances commutées à extension de drain pondérée et/ou un réseau de résistances commutées à extension de source pondérée. Dans cette représentation, à titre d'exemple, d'un transistor MOS 300 du type n, les zones de source, de métallisation de la source, d'oxyde de grille, de grille, de drain, d'extension de drain servant de résistance, et de métallisation de l'extension de drain correspondent respectivement aux références 305a, 305b, 310, 315, 320, 325a, 325b. La couche d'oxyde épais et le substrat correspondent respectivement aux zones 330 et 335.

La zone d'extension de drain 325a, laquelle est disposée sur le côté du drain opposé à celui qui fait face au canal du transistor, correspond au drain 320 le plus proche. Dans cet exemple, la partie la plus éloignée de cette même zone d'extension de drain est indiquée par la référence 325d. Les zones 325b et 325c correspondent respectivement à des zones de métallisation de l'extension de drain des zones 325a et 325d. Mis à part le fait que le réseau de résistances à extension de drain peut être fabriqué en même temps que la zone de drain, l'utilisation d'une zone d'extension de drain présente l'avantage d'augmenter la capacité d'amorçage de la résistance et du transistor.

La figure 3b représente un mode de réalisation d'une vue de dessus d'un réseau de résistances serpenté à pondération binaire progressive. Dans cet exemple particulier, une résistance pondérée à 5 éléments binaires est représentée. Elle possède des contacts métalliques appropriés indiqués par les zones hachurées 305b, 325b 327, 328, 326 et 325c. Ces contacts métalliques sont réalisés sur chaque extrémité de résistances et correspondent à ceux de la figure 3a. La résistance R(1) est représentée par le bloc la et la résistance R(2) = 2xR(1) est représentée par les blocs 1b et 2b et ainsi de suite, la résistance R(5) étant représentée par les seize blocs 1e à 16e. De cette façon, la longueur de l'extension de drain détermine la valeur de résistance de la résistance, tous les autres paramètres variables étant bien entendu fixés.

La figure 3c représente un schéma des circuits équivalent à celui de la figure 3a, c'est à dire un transistor MOS MN1 équivalent au transistor 300, du type n avec un réseau de résistances à extension de drain pondéré en série. Pour chaque résistance, un interrupteur, sous forme de transistor, est disposé en parallèle. A titre d'exemple, la résistance R(5) possède un transistor MN5 du type n disposé en parallèle avec elle, le transistor MN5 étant commandé, par l'intermédiaire de sa grille, par la sortie de commande C(5) ; la résistance R(1) possède un transistor MN1 du type n disposé en parallèle avec elle, le transistor MN1 étant commandé, par l'intermédiaire de sa grille 315, par le signal de commande /C(1). La figure 3a est une vue en coupe selon le tracé représenté sur la figure 3b. Le transistor 300-MN1 y est montré en parallèle avec la résistance 1a.

Même si cette invention a été décrite par rapport à certains modes de réalisation préférés, il est clair que le présent exposé doit être considéré comme une explication, au moyen d'exemples, des principes de l'invention et qu'il n'est pas question de limiter l'invention aux modes de réalisation décrits. Il est possible de régler la valeur de résistance des réseaux de résistances 110, SR(1) ... SR(X), en reliant ou en ne reliant pas leurs résistances respectives en parallèle, comme c'est le cas avec la technique de chaîne de résistances commutées. De façon alternative, les réseaux 110, SR(1) ... SR(X) peuvent être mis en oeuvre et commandés de façon appropriée avec un mélange de résistances reliées en série et de résistances reliées en parallèle selon la conception requise et/ou les besoins de fabrication.

## Revendications

1. Circuit étalon de résistances caractérisé en ce qu'il comprend :
- une résistance étalon (105) sensiblement indépendante d'un facteur physique déterminé auquel est soumis le circuit étalon de résistance ;
- un réseau de résistances (110) qui dépend dudit facteur physique déterminé ;
- un circuit de source de courant (115) destiné à fournir respectivement un premier et un deuxième courant (I1, I2) à la résistance étalon (105) et au réseau de résistances (110) ;
- un circuit comparateur et logique (120) comportant :
- un comparateur (135) sensible aux tensions (V1, V2) établies à travers la résistance étalon (105) et le réseau de résistances (110) et
- une multiplicité d'interrupteurs (S(1) ... S(N)) reliés respectivement aux résistances dudit réseau de résistances (110), lesdits interrupteurs (S(1) ... S(N)) étant commandés par le comparateur (135) de manière à modifier la valeur de résistance du réseau de résistances (110) de façon à ce que la valeur de résistance du réseau de résistances (110) soit maintenue sensiblement à un niveau correspondant à celui de la résistance étalon (105).

2. Circuit selon la revendication 1, caractérisé en ce que le facteur physique est la température.

3. Circuit selon l'une des revendications 1 ou 2, caractérisé en ce que le circuit de source de courant (115) comporte une première et une deuxième source de courant fournissant respectivement un premier et un deuxième courant (I1, I2), lesdits premier et deuxième courants étant sensiblement égaux.

4. Circuit selon l'une des revendications 1 à 3, caractérisé en ce que le réseau de résistances (110) comprend une multiplicité de résistances reliées en série (R(1) ... R(N)).

5. Circuit selon l'une des revendications 1 à 3, caractérisé en ce que le réseau de résistances (110) comprend une multiplicité de résistances reliées en parallèle.

6. Circuit selon l'une des revendications 1 à 5, caractérisé en ce que le circuit (120) comparateur et logique comporte un compteur (140).

7. Circuit selon la revendication 6, caractérisé en ce que le compteur (140) est un compteur-décompteur binaire à N éléments binaires.

8. Circuit selon les revendications 6 ou 7, caractérisé en ce que le compteur (140) est sensible à un signal d'horloge (CLK), à un signal de restauration (RST), et à la sortie du comparateur (135).

9. Circuit selon l'une des revendications 6 à 8, caractérisé en ce que la commande de la multiplicité d'interrupteurs est relayée par l'intermédiaire d'un bus de données (205).

10. Circuit selon la revendication 9, caractérisé en ce qu'il comprend en outre un élément de stockage (210) relié au bus de données (205).

11. Circuit selon la revendication 10, caractérisé en ce que l'élément de stockage (210) est une mémoire EEPROM.

12. Circuit selon l'une des revendications 1 à 11, caractérisé en ce qu'il comporte en outre un ou plusieurs autres réseaux de résistances commutées (SR(1) ... SR(X)) modifiés en concordance avec le réseau de résistances (110).

13. Circuit selon la revendication 12, caractérisé en ce que lesdits un ou plusieurs autres réseaux de résistances commutées (SR(1) ... SR(X)) constituent des extensions de drain et/ou de source de transistor du type MOS.

14. Circuit selon l'une des revendications 1 à 13, caractérisé en ce que le réseau de résistances (110) constitue l'extension de drain et/ou de source d'un transistor du type MOS.

15. Circuit selon l'une des revendications 1 à 14, caractérisé en ce que les résistances du ou des réseaux de résistances sont pondérées en binaire.

## Claims

1. Calibration circuit for resistors characterised in that it comprises:
- a reference resistor (105) substantially independent of a given physical factor to which the resistor calibration circuit is subject;
- an array of resistors (110) which depends upon the said given physical factor;
- a current source circuit (115) intended to supply respectively a first and a second current (I1, I2) to the reference resistor (105) and to the array of resistors (110);
- a comparison logic circuit (120) including:
- a comparator (135) sensitive to the voltages (V1, V2) established through the reference resistor (105) and the array of resistors (110), and
- a multiplicity of switches (S(1) ... S(N)) connected respectively to the resistors in the said array of resistors (110), the said switches (S(1) ... S(N)) being controlled by the comparator (135) so as to modify the resistance value of the array of resistors (110) so that the resistance value of the array of resistors (110) is maintained substantially at a level corresponding to that of the reference resistor (105).

2. Circuit according to Claim 1, characterised in that the physical factor is the temperature.

3. Circuit according to one of Claims 1 or 2, characterised in that the current source circuit (115) has a first and a second current source supplying respectively a first and a second current (I1, I2), the said first and second currents being substantially equal.

4. Circuit according to one of Claims 1 to 3, characterised in that the array of resistors (110) comprises a multiplicity of resistors connected in series (R(1) ... R(N)).

5. Circuit according to one of Claims 1 to 3, characterised in that the array of resistors (110) comprises a multiplicity of resistors connected in parallel.

6. Circuit according to one of Claims 1 to 5, characterised in that the comparison logic circuit (120) includes a counter (140).

7. Circuit according to Claim 6, characterised in that the counter (140) is a binary counter-downcounter with N binary elements.

8. Circuit according to Claims 6 or 7, characterised in that the counter (140) is sensitive to a clock signal (CLK), to a restoration signal (REST) and to the output of the comparator (135).

9. Circuit according to one of Claims 6 to 8, characterised in that the command for the multiplicity of switches is relayed by means of a data bus (205).

10. Circuit according to Claim 9, characterised in that it also comprises a storage element (210) connected to the data bus (205).

11. Circuit according to Claim 10, characterised in that the storage element (210) is an EEPROM memory.

12. Circuit according to one of Claims 1 to 11, characterised in that it also includes one or more other arrays of switched resistors (SR(1) ... SR(X)) modified in accordance with the array of resistors (110).

13. Circuit according to Claim 12, characterised in that the said one or more other arrays of switched resistors (SR(1) ... SR(X)) constitute MOS-type transistor drain and/or source extensions.

14. Circuit according to one of Claims 1 to 13, characterised in that the array of resistors (110) constitutes the drain and/or source extension of an MOS-type transistor.

15. Circuit according to one of Claims 1 to 14, characterised in that the resistors in the array or arrays of resistors are weighted in binary.

## Patentansprüche

1. Schaltkreis zum Abgleichen von Widerständen, gekennzeichnet durch:
- einen Abgleichwiderstand (105), der im wesentlichen unabhängig von einem bestimmten physikalischen Faktor ist, dem der Schaltkreis zum Abgleichen von einem Widerstand unterworfen ist,
- ein Widerstandsnetz (110), das von dem bestimmten physikalischen Faktor abhängt,
- einen Stromquellenschaltkreis (115), der dazu dient, jeweils einen ersten und einen zweiten Strom (I1, I2) durch den Abgleichwiderstand (105) in das Netz von Widerständen (110) fließen zu lassen,
- einen Logik- und Komparatorschaltkreis (120), der umfaßt:
- einen Komparator (135), der auf Spannungen (V1, V2) reagiert, die über dem Abgleichwiderstand (105) und dem Netz von Widerständen (110) abfallen, und
- eine Vielzahl von Unterbrechern (S(1), ... (S(N)), die jeweils mit den Widerständen des Widerstandsnetzes (110) verbunden sind, wobei die Unterbrecher (S(1) ... S(N)) durch den Komparator (135) gesteuert werden, so daß der Wert des Widerstandes des Widerstandsnetzes (110) modifiziert wird, so daß der Wert des Widerstandes des Widerstandsnetzes (110) im wesentlichen auf einem Wert gehalten wird, der dem des Abgleichwiderstandes (105) entspricht.

2. Schaltkreis nach Anspruch 1, dadurch gekennzeichnet, daß der physikalische Faktor die Temperatur ist.

3. Schaltkreis nach einem der Ansprüche 1 oder 2, dadurch gekennzeichnet, daß der Stromquellenschaltkreis (115) eine erste und eine zweite Stromquelle umfaßt, die jeweils einen ersten und einen zweiten Strom (I1, I2) ausgeben, wobei der erste und der zweite Strom im wesentlichen gleich sind.

4. Schaltkreis nach einem der Ansprüche 1 bis 3, dadurch gekennzeichnet, daß das Widerstandsnetz (110) eine Vielzahl von Widerständen umfaßt, die in Reihe geschaltet sind (R(1) ... R(N)).

5. Schaltkreis nach einem der Ansprüche 1 bis 3, dadurch gekennzeichnet, daß das Widerstandsnetz (110) eine Vielzahl von Widerständen umfaßt, die parallel geschaltet sind.

6. Schaltkreis nach einem der Ansprüche 1 bis 5, dadurch gekennzeichnet, daß der Komparator- und Logikschaltkreis (120) einen Zähler (140) umfaßt.

7. Schaltkreis nach Anspruch 6, dadurch gekennzeichnet, daß der Zähler (140) ein binärer Aufwärts-Abwärts-Zähler mit N binären Elementen ist.

8. Schaltkreis nach Anspruch 6 oder 7, dadurch gekennzeichnet, daß der Zähler (140) auf ein Taktsignal (CLK), ein Reset-Signal (RST) und das Ausgangssignal des Komparators (135) reagiert.

9. Schaltkreis nach einem der Ansprüche 6 bis 8, dadurch gekennzeichnet, daß die Steuerung der Vielzahl von Unterbrechern über einen Datenbus (205) erfolgt.

10. Schaltkreis nach Anspruch 9, dadurch gekennzeichnet, daß er außerdem ein Speicherelement (210) umfaßt, das mit dem Datenbus (205) verbunden ist.

11. Schaltkreis nach Anspruch 10, dadurch gekennzeichnet, daß das Speicherelement (210) ein EEPROM-Speicher ist.

12. Schaltkreis nach einem der Ansprüche 1 bis 11, dadurch gekennzeichnet, daß er außerdem ein oder mehrere andere Widerstandsnetze (SR(1) ... SR(X)) umfaßt, die schaltbar sind und in Übereinstimmung mit dem Widerstandsnetz (110) modifiziert sind.

13. Schaltkreis nach Anspruch 12, dadurch gekennzeichnet, daß das eine oder mehrere weitere schaltbare Widerstandsnetze (SR(1) ... SR(X)) die Drain- und/oder Source-Anschlüsse eines MOS-Transistors bilden.

14. Schaltkreis nach einem der Ansprüche 1 bis 13, dadurch gekennzeichnet, daß das Widerstandsnetz (110) den Drain- und/oder Source-Anschluß eines MOS-Transistors bildet.

15. Schaltkreis nach einem der Ansprüche 1 bis 14, dadurch gekennzeichnet, daß die Widerstände des oder der Widerstandsnetze binär gewichtet sind.
